# EUROPÄISCHE PATENTSCHRIFT

(11) **EP 2 956 396 B1**
(45) Veröffentlichungstag und Bekanntmachung des Hinweises auf die Patenterteilung: **29.03.2017**
(21) Anmeldenummer: 14701503.6
(22) Anmeldetag: 20.01.2014
(51) Int. Cl.: B66B 5/00, B66B 13/22, B66B 29/00

(54) **BATTERIEGESTÜTZTE SICHERHEITSKREIS-ÜBERWACHUNGSANLAGE**
BATTERY-ASSISTED SAFETY CIRCUIT MONITORING SYSTEM
INSTALLATION DE SURVEILLANCE DE CIRCUIT DE SÉCURITÉ FONCTIONNANT SUR BATTERIE

(30) Priorität: 12.02.2013 EP 13154905
(43) Veröffentlichungstag der Anmeldung: 23.12.2015
(73) Patentinhaber: Inventio AG, 6052 Hergiswil (CH)
(72) Erfinder: LUSTENBERGER, Ivo, 6018 Buttisholz (CH)
(86) Internationale Anmeldenummer: PCT/EP2014/050973
(87) Internationale Veröffentlichungsnummer: WO 2014/124779

(56) Entgegenhaltungen:
- JP-A- H1 121 052
- US-B1- 6 193 019

## Beschreibung

Die Erfindung betrifft eine Überwachungsanlage für Personentransportanlagen, die als Aufzug, Rolltreppe oder Fahrsteig ausgestaltet sind, solch eine Personentransportanlage und ein Verfahren für solch eine Personentransportanlage. Speziell betrifft die Erfindung das Gebiet der Aufzugsanlagen.

Aus der US 6,193,019 B1 ist eine Einrichtung zur Überwachung von Türen einer Aufzugsanlage bekannt, wobei die Türen auf mehreren Stockwerken vorhanden sind. Hierbei ist ein Sicherheitskreis in Form einer Kette von Schaltern vorhanden, die an Schlössern der Türen angeordnet sind. Parallel zu jedem dieser Schalter ist ein Widerstand geschaltet. Der jeweilige Widerstand ist bei geschlossenem Schalter überbrückt. Die Widerstandswerte sind als Produkt aus einem Zweierpotenz und einem Bezugswiderstand gebildet. Der Exponent, der eine nicht negative ganze Zahl ist, entspricht hierbei dem Stockwerk, auf dem die Tür angeordnet ist, auf die sich das Schloss mit dem zugeordneten Widerstand bezieht. Wenn ein oder mehrere Schalter geöffnet sind, dann kann aus der Summe der Widerstände an den offenen Schaltern, die den diesbezüglichen Gesamtwiderstand der Widerstände an den offenen Schaltern angibt, berechnet werden, welche Schalter offen sind. Dies kann über eine geeignete Anzeigeeinrichtung ausgegeben werden.

Die aus der US 6,193,019 B1 bekannte Einrichtung zur Überwachung der Türen einer Aufzugsanlage hat den Nachteil, dass ein Öffnen und anschließendes Schließen eines Schlosses nicht erkannt werden kann, wenn die Energieversorgung während dieses Zeitraums unterbrochen ist.

Aus der EP 1 440 930 A2 ist ein Türverschluss für eine Tür eines Aufzuges bekannt. Der bekannte Türverschluss weist ein Gehäuse und einen Riegel auf, wobei der Riegel bezüglich der Tür in eine Verriegelungsstellung und in eine Freigabestellung überführbar ist. Der Riegel ist hierbei in dem Gehäuse gelagert. Der Verschluss weist eine manuelle betätigbare Notentriegelung zur Überführung des Riegels in seine Freigabestellung auf, wobei die Notentriegelung einen Mitnehmer aufweist, der unter Überführung des Riegels in die Freigabestellung durch einen Notentriegelungsschlüssel betätigbar ist. Außerdem ist an oder in dem Gehäuse ein zwangsöffnender Sicherheitsschalter oder zumindest ein Teil einer entsprechenden elektrischen Sicherheitsschaltung und ein diesem beziehungsweise dieser zugeordneter manuell betätigbarer Mitnehmer zur Betätigung des Sicherheitsschalters beziehungsweise der Sicherheitsschaltung vorhanden. Der Türverschluss kann derart ausgeführt sein, dass durch Betätigung der Notentriegelung zunächst der Sicherheitsschalter betätigt und zeitlich nachfolgend hierzu der Riegel in seine Freigabestellung überführt wird. Durch einen Sicherheitsstromkreis ist unter Schaltung des Sicherheitsschalters ein Normalbetrieb einer der Tür zugeordneten Einrichtung unterbrechbar und wieder aufnehmbar.

Speziell bei Aufzuganlagen, die einen reduzierten Schachtkopf oder keinen Schachtkopf im Aufzugsschacht haben, ist eine Überwachung von Türverschlüssen, insbesondere Dreikantschlössern, von Schachttüren erforderlich. Dadurch kann festgestellt werden, ob jemand auf das Kabinendach der Aufzugskabine gelangen konnte. Beim Öffnen eines Dreikantschlosses wird ein Sicherheitsschalter geöffnet, der einen Sicherheitskreis unterbricht. Wenn der Sicherheitsschalter, wie in der EP 1 440 930 A2 beschrieben, eine Rastfunktion aufweist, dann wird die Aufzugsanlage festgesetzt, bis ein Servicetechniker diese nach einer geeigneten Überprüfung wieder in Betrieb nimmt. Wenn aber nun beispielsweise eine Energieversorgung zeitweilig ausfällt, dann wird ein Öffnen und anschließendes Schließen des Schalters nicht erkannt. Wird diesem Problem nicht Rechnung getragen, dann kann jemand unerkannt in den Aufzugsschacht, insbesondere auf das Kabinendach, gelangen, ohne dass dies erkannt wird, wodurch es zu schwerwiegenden Unfällen kommen kann. Um dem Rechnung zu tragen, ist es denkbar, dass nach einem Stromausfall die Inbetriebnahme der Aufzugsanlage nur nach einem vorgeschriebenen Inbetriebabnahmeablauf durch einen autorisierten Servicetechniker erfolgen darf. Dies muss dann allerdings stets erfolgen, unabhängig davon, ob jemand eine Tür geöffnet hat oder nicht. Dies führt auch bei vergleichsweise kurzen Ausfällen der Energieversorgung zu einer wesentlichen Störung des Betriebsablaufs, da die Aufzugsanlage für einen vergleichsweise langen Zeitraum ausfällt, der unter anderem durch die Dauer bis zum Eintreffen des Servicetechnikers und die Dauer zur Durchführung des Inbetriebnahmeablaufs bestimmt ist.

Aufgabe der Erfindung ist es, eine Überwachungsanlage für Personentransportanlagen, die als Aufzug, Rolltreppe oder Fahrsteig ausgestaltet sind, solch eine Personentransportanlage und ein Verfahren zur Überwachung solch einer Personentransportanlage anzugeben, die verbessert ausgestaltet sind. Speziell ist es eine Aufgabe der Erfindung, eine Überwachungsanlage für Personentransportanlagen, die als Aufzug, Rolltreppe oder Fahrsteig ausgestaltet sind, solch eine Personentransportanlage und ein Verfahren zur Überwachung solch einer Personentransportanlage anzugeben, die eine verbesserte Überwachung zumindest einer Einrichtung der Personentransportanlage ermöglichen, wobei auch im stromlosen Zustand der Personentransportanlage eine Überwachung ermöglicht ist. Insbesondere kann hierdurch ermöglicht werden, dass die Personentransportanlage nach einem Stromausfall selbständig wieder in eine Normalfahrt geht, falls zwischenzeitlich keine überwachte Schachttüre oder dergleichen geöffnet worden ist.

Die Aufgabe wird durch eine Überwachungsanlage für Personentransportanlagen gelöst, die als Aufzug, Rolltreppe oder Fahrsteig ausgestaltet sind. Die Überwachungsanlage beinhaltet zumindest eine Abfrageeinrichtung und zumindest einen über einen elektrischen Sicherheitskreis mit der Abfrageeinrichtung verbundenen Sicherheitsschalter, der zur Überwachung einer Einrichtung der Personentransportanlage dient. Der Sicherheitsschalter weist mindestens zwei Schaltstellungen auf. Ferner ist eine unabhängige Energieversorgungseinrichtung vorhanden, welche die Abfrageeinrichtung mit elektrischer Energie versorgt. Dadurch kann mittels der Abfrageeinrichtung unabhängig vom Vorhandensein einer externen Energieversorgung der Personentransportanlage, eine Änderung der Schaltstellung des Sicherheitsschalters erfasst und aus der Änderung der Schaltstellung mindestens ein Zustandssignal generiert werden. Das Zustandssignal kann dank der unabhängigen Energieversorgungseinrichtung in der Abfrageeinrichtung gespeichert sein und durch eine Steuerung der Personentransportanlage abgerufen werden, sobald diese nach einem Stromausfall dazu wieder in der Lage ist.

Vorteilhaft ist es, dass die unabhängige Energieversorgungseinrichtung an der Abfrageeinrichtung angeordnet ist. Hierbei kann die unabhängige Energieversorgungseinrichtung insbesondere in einem gemeinsamen Gehäuse mit der Abfrageeinrichtung untergebracht sein. Ferner ist es vorteilhaft, dass die Abfrageeinrichtung ausgestaltet ist, eine Prüfspannung an den elektrischen Sicherheitskreis anzulegen. Die Prüfspannung kann insbesondere bei einer Unterbrechung einer externen Energieversorgung aufgrund der bestehenden unabhängigen Energieversorgungseinrichtung erzeugt werden.

Vorteilhaft ist es auch, dass die unabhängige Energieversorgungseinrichtung zumindest ein Batterieelement und/oder zumindest ein Akkumulatorelement aufweist. Das Batterieelement und/oder das Akkumulatorelement kann hierbei im Rahmen einer regelmäßigen Wartung überprüft und gegebenenfalls ausgetauscht werden. Die Ausgestaltung als Akkumulatorelement hat den Vorteil, dass zum einen eine Ladung über eine externe Energieversorgung möglich ist. Zum anderen stellt das Akkumulatorelement sowohl bei bestehender als auch bei unterbrochener externer Energieversorgung die von der Abfrageeinrichtung benötigte Betriebsspannung stets in einer gewünschten Höhe zur Verfügung, wenn die externe Energieversorgung zum Laden des Akkumulatorelements dient.

Vorteilhaft ist es auch, dass die Abfrageeinrichtung zumindest mittelbar von einer externen Energieversorgung versorgbar ist und dass die Abfrageeinrichtung zumindest bei einer Unterbrechung der externen Energieversorgung von der unabhängigen Energieversorgungseinrichtung versorgbar ist. Zusätzlich oder alternativ ist es somit von Vorteil, dass die externe Energieversorgung zum Laden des zumindest einen Akkumulatorelements dient. Insbesondere kann die Abfrageeinrichtung mittels des Akkumulatorelements beziehungsweise einer Einrichtung, die auch zum Laden des Akkumulatorelements dient, versorgt werden, wobei zugleich eine Ladung des Akkumulatorelements möglich ist.

Vorteilhaft ist es ferner, dass der Sicherheitsschalter als umschaltbarer Sicherheitsschalter ausgestaltet ist, dass der Sicherheitsschalter in einer ersten Schaltstellung den Sicherheitskreis über ein erstes Leitungsstück, das zumindest mittelbar mit der Abfrageeinrichtung verbunden ist, schließt und dass der Sicherheitsschalter in einer zweiten Schaltstellung den Sicherheitskreis über ein zweites Leitungsstück, das zumindest mittelbar mit der Abfrageeinrichtung verbunden ist, schließt. Hierbei ist es außerdem von Vorteil, dass das erste Leitungsstück mit einem ersten Eingangs- und/oder Ausgangsanschluss der Abfrageeinrichtung verbunden ist, dass das zweite Leitungsstück mit einem zweiten Eingangs- und/oder Ausgangsanschluss der Abfrageeinrichtung verbunden ist, dass eine Rückleitung vorhanden ist, die mit einem dritten Eingangs- und/oder Ausgangsanschluss der Abfrageeinrichtung verbunden ist, dass der Sicherheitsschalter in der ersten Schaltstellung den Sicherheitskreis über das erste Leitungsstück und über die Rückleitung schließt und dass der Sicherheitsschalter in der zweiten Schaltstellung den Sicherheitskreis über das zweite Leitungsstück und die Rückleitung schließt. Die Einrichtung der Personentransportanlage, die überwacht wird, kann beispielsweise als Türschloss ausgestaltet sein. Dann kann sowohl der offene Zustand des Türschlosses als auch der geschlossene Zustand des Türschlosses über die beiden Schaltstellungen des zugeordneten Sicherheitsschalters abgefragt werden. Auch beim Unterbrechen einer externen Energieversorgung ist dies durchgehend möglich, da die unabhängige Energieversorgungseinrichtung für die Abfrageeinrichtung vorgesehen ist. Somit kann nach der Unterbrechung der externen Energieversorgung beispielsweise an eine Steuerung, insbesondere eine Aufzugssteuerung, gemeldet werden, ob ein zwischenzeitliches Öffnen des Türschlosses erfolgt ist oder nicht. Falls das Türschloss stets geschlossen war, dann besteht diesbezüglich kein sicherheitsrelevanter Grund, ein entsprechendes Zustandssignal zu generieren und den Betrieb der Aufzugsanlage zu unterbrechen. Somit kann der Betrieb der Personentransportanlage, insbesondere der Aufzugsanlage, selbsttätig wieder aufgenommen werden. Unnötige Unterbrechungen des Betriebs nach einem Stromausfall können somit vermieden werden.

Allerdings wird auch ein Öffnen während eines Stromausfalls zuverlässig erkannt. Dies ermöglicht dann auch eine konkrete Meldung des sicherheitsrelevanten Grundes beziehungsweise der Übermittlung eines entsprechenden Zustandssignals für eine Unterbrechung nach einem Stromausfall. Beispielsweise kann gezielt das Stockwerk oder die konkrete Einrichtung, insbesondere das Türschloss, als sicherheitsrelevanter Grund für die Unterbrechung gespeichert und einem Servicetechniker angezeigt werden. Dies vereinfacht die Suche und verringert den Aufwand für eine Wiederinbetriebnahme. Außerdem wird die Sicherheit verbessert, da der sicherheitsrelevante Grund explizit angezeigt wird und somit nicht übersehen werden kann. Dies ist auch dann von Bedeutung, wenn kumulativ mehrere Ursachen für eine Unterbrechung bestehen. Beispielsweise kann neben dem beschriebenen zeitweise geöffneten Türschloss ein weiteres Türschloss weiterhin offen sein. Der Servicetechniker kann dann nicht nur das geöffnete weitere Türschloss als Ursache erkennen, sondern auch das nur während der Stromunterbrechung zeitweise geöffnete Türschloss. Hierdurch wird auch die Sicherheit verbessert.

In vorteilhafter Weise ist in dem Sicherheitskreis zumindest eine stromrichtungsabhängige Einheit vorhanden, wobei die Abfrageeinrichtung ausgestaltet ist, eine Prüfspannung mit einer wechselnden Polarität an den elektrischen Sicherheitskreis anzulegen. Die stromrichtungsabhängige Einheit weist eine stromrichtungsabhängige elektrische Eigenschaft auf. Ferner ist es hierbei vorteilhaft, dass die Abfrageeinheit ausgestaltet ist, die Prüfspannung stets zwischen einem ersten Anschluss und einem zweiten Anschluss an den elektrischen Sicherheitskreis anzulegen. Somit werden an der Abfrageeinheit nur zwei Anschlüsse benötigt. Dies ermöglicht außerdem eine Ausgestaltung, bei der nur zwei elektrische Leitungen oder zumindest abschnittsweise nur zwei elektrische Leitungen vorhanden sind. Somit vereinfacht sich die Ausgestaltung der Überwachungsanlage.

Hierbei ist es ferner vorteilhaft, dass der zumindest eine Sicherheitsschalter in einer ersten Schaltstellung, beziehungsweise wenn mehrere Sicherheitsschalter in der Sicherheitskette vorhanden sind, in einer ersten Kombination von Schaltstellungen den Sicherheitskreis über die stromrichtungsabhängige Einheit schließt. Außerdem kann der zumindest eine Sicherheitsschalter in einer zweiten Schaltstellung beziehungsweise in einer anderen Kombination von Schaltstellungen, die sich von der ersten Kombination von Schaltstellungen unterscheidet, den Sicherheitskreis öffnen. Somit ist bei geöffnetem Sicherheitsschalter unabhängig von der Polarität der Prüfspannung kein Stromsignal erfassbar. Somit kann auf den geöffneten Sicherheitsschalter geschlossen werden. Eine gegebenenfalls vorhandene Störung, die ebenfalls zu keinem Stromfluss führt, kann dann wie ein geöffneter Schalter behandelt werden. Somit kann beispielsweise auch ein Leitungsbruch zuverlässig erkannt werden.

Vorteilhaft ist es bei einer abgewandelten Ausgestaltung allerdings auch, dass der zumindest eine Sicherheitsschalter in einer zweiten Schaltstellung beziehungsweise in einer anderen Kombination von Schaltstellungen, die sich von der ersten Kombination von Schaltstellungen unterscheidet, den Sicherheitskreis nicht über die stromrichtungsabhängige Einheit, sondern über eine weitere stromrichtungsabhängige Einheit mit einer stromrichtungsabhängigen elektrischen Eigenschaft schließt. Somit kann durch Anlegen der Prüfspannung mit der wechselnden Polarität an den Sicherheitskreis erkannt werden, ob der Sicherheitskreis das durch die stromrichtungsabhängige Einheit gegebene Verhalten oder das durch die weitere stromrichtungsabhängige Einheit gegebene Verhalten zeigt. Somit kann eindeutig zwischen der ersten Schaltstellung und der zweiten Schaltstellung des Sicherheitsschalters beziehungsweise der einen Kombination von Schaltstellungen und jeder anderen Kombination von Schaltstellungen unterschieden werden. Zusätzlich können hierbei auch Störungen, die sich in einem Kurzschluss oder einer Unterbrechung auswirken, zuverlässig erkannt werden. Denn bei diesen Störungen ergibt sich jeweils ein von der Stromrichtung unabhängiges Verhalten des Sicherheitskreises. Entsprechend können durch eine geeignete Auswertung auch andere Störungen erkannt werden, beispielsweise ein Kurzschluss, der einen Sicherheitsschalter von mehreren Sicherheitsschaltern überbrückt.

Außerdem ist es vorteilhaft, dass eine Steuereinrichtung vorhanden ist, die die Abfrageeinrichtung umfasst, und dass die Steuereinrichtung bei einer Betätigung der Einrichtung, die von dem Sicherheitsschalter überwacht ist, über eine Schnittstelle und ein Bussystem die Betätigung an eine zentrale Steuerung meldet. Bei der zentralen Steuerung kann es sich insbesondere um eine Aufzugssteuerung handeln. Hierbei ist es ferner vorteilhaft, dass auf jedem Stockwerk eine Zielrufeingabeeinheit mit einer RFID-Schnittstelle vorhanden ist und dass die RFID-Schnittstelle über die Schnittstelle mit dem Bussystem verbunden ist. Somit kann die für die RFID-Schnittstelle ohnehin erforderliche Schnittstelle zu dem Bussystem auch von der Überwachungseinrichtung genutzt werden. Somit reduziert sich der Herstellungsaufwand.

Wie vorangehend ausgeführt, ist eine sichere Abfrage eines Schlosses, insbesondere eines Dreikantschlosses, oder einer anderen Einrichtung der Personentransportanlage über den Sicherheitskreis möglich. Wenn eine externe Energieversorgung für die Personentransportanlage unterbrochen wird und während dieser Zeit sich jemand beispielsweise zu einem Aufzugsschacht Zutritt verschafft und die Schachttüre wieder verschließt, dann kann solch ein Zutritt dennoch zuverlässig festgestellt werden. Die Abfrageeinrichtung, die Teil einer Steuereinrichtung sein kann, stellt sicher, dass die Stellung des Sicherheitsschalters korrekt erfasst wird. Je nach Ausgestaltung des Sicherheitsschalters können hierfür ein Öffner- und ein Schließerkontakt des Sicherheitsschalters vorhanden sein, wobei die Schaltstellungen antivalent eingelesen werden. Bei einer möglichen Ausgestaltung ist außerdem eine dynamische Speisung in Form der Prüfspannung mit der wechselnden Polarität möglich. Dies ermöglicht ein korrektes Rücklesen über die Eingangsanschlüsse der Abfrageeinrichtung. Hierbei können in vorteilhafter Weise eine oder mehrere stromrichtungsabhängige Einheiten zum Einsatz kommen. Solch eine stromrichtungsabhängige Einheit kann beispielsweise durch eine Diode gebildet sein oder eine Diode umfassen.

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigen:
- Figur 1: eine Überwachungsanlage für eine Personentransportanlage in einer auszugsweisen, schematischen Darstellung entsprechend einem ersten Ausführungsbeispiel der Erfindung;
- Figur 2: eine Überwachungsanlage für eine Personentransportanlage in einer auszugsweisen, schematischen Darstellung entsprechend einem zweiten Ausführungsbeispiel der Erfindung;
- Figur 3: eine Überwachungsanlage für eine Personentransportanlage in einer auszugsweisen, schematischen Darstellung entsprechend einem dritten Ausführungsbeispiel der Erfindung;
- Figur 4: eine Überwachungseinrichtung für eine Personentransportanlage in einer auszugsweisen, schematischen Darstellung entsprechend einem vierten Ausführungsbeispiel der Erfindung und
- Figur 5: eine Überwachungsanlage für eine Personentransportanlage in einer auszugsweisen, schematischen Darstellung entsprechend einem fünften Ausführungsbeispiel der Erfindung.

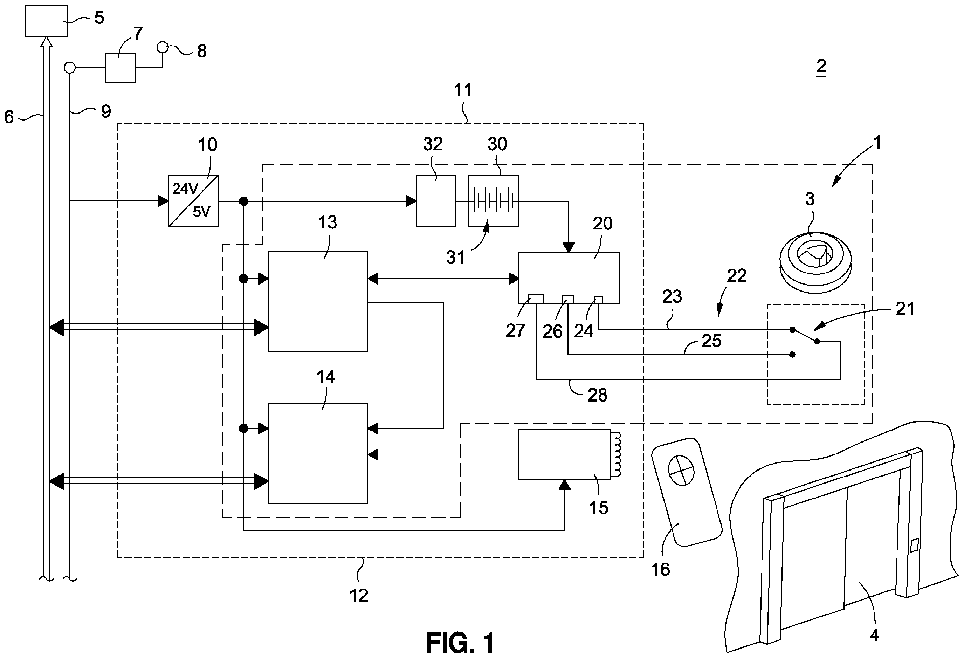

Figur 1 zeigt eine Überwachungsanlage 1 für eine Personentransportanlage 2 in einer auszugsweisen, schematischen Darstellung in einem ersten Ausführungsbeispiel. Die Personentransportanlage 2 ist in diesem Ausführungsbeispiel als Aufzugsanlage 2 ausgestaltet. Im Allgemeinen kann die Personentransportanlage 2 als Aufzug (Aufzugsanlage), Rolltreppe oder Fahrsteig ausgestaltet sein. Die Überwachungsanlage 1 ist dann Bestandteil der Personentransportanlage 2. Die Überwachungsanlage 1 kann allerdings auch unabhängig von einer Personentransportanlage 2 hergestellt oder vertrieben werden. Die Überwachungsanlage 1 dient zum Überwachen einer Einrichtung 3 der Personentransportanlage 2. Die Einrichtung 3 ist hierbei nicht notwendigerweise Bestandteil der Überwachungsanlage 1. Allerdings kann die Einrichtung 3 je nach Ausgestaltung der Überwachungsanlage 1 auch ganz oder teilweise Bestandteil der Überwachungsanlage 1 sein.

Die Personentransportanlage 2 weist in diesem Ausführungsbeispiel eine Tür 4 auf, die als Schachttür 4 ausgebildet ist. Die Tür 4 befindet sich hierbei auf einem Stockwerk eines Gebäudes, in dem die Aufzugsanlage 2 installiert ist. Die Einrichtung 3 ist der Tür 4 zugeordnet. Bei der Einrichtung 3 handelt es sich in diesem Ausführungsbeispiel um ein Schloss 3, das als Türschloss 3 ausgestaltet ist. Speziell ist das Türschloss 3 in diesem Ausführungsbeispiel als Dreikantschloss 3 ausgestaltet. Durch ein Öffnen oder Schließen des Türschlosses 3 kann die Tür 4 entriegelt beziehungsweise verriegelt werden. Im entriegelten Zustand kann die Tür 4 manuell geöffnet werden. Dadurch kann beispielsweise eine Bedienperson, insbesondere ein Servicetechniker oder eine Wartungsperson, in einen nicht dargestellten Aufzugsschacht und gegebenenfalls auch auf ein Kabinendach einer Aufzugskabine der Aufzugsanlage 2 gelangen.

Die Überwachungsanlage 1 weist eine zentrale Steuerung 5 auf, die in eine Aufzugssteuerung oder dergleichen integriert sein kann. Die zentrale Steuerung 5 ist an ein Bussystem 6 angebunden. Das Bussystem 6 kann hierbei als gemeinsames Bussystem 6 für die Personentransportanlage 2 dienen. Das Bussystem 6 kann aber auch als ein exklusives Bussystem 6 für die Überwachungsanlage 1 zur Verfügung stehen. Ferner ist eine externe Energieversorgung 7 vorhanden, die beispielsweise über einen Netzanschluss 8 mit einem Stromnetz verbunden ist. In diesem Ausführungsbeispiel stellt die externe Energieversorgung 7 über eine Versorgungsleitung 9 eine Versorgungsspannung von 24 V zur Verfügung. Die Versorgungsleitung 9 kann hierbei parallel zu dem Bussystem 6 geführt sein.

Im Bereich der Tür 4 ist ein Umsetzer 10 vorhanden, der die Versorgungsspannung von 24 V aus der Versorgungsleitung 9 in eine Versorgungsspannung von 5 V umsetzt, die innerhalb einer baulichen Einheit 11 von einer lokalen Versorgungsleitung 12 abgegriffen werden kann.

Innerhalb der baulichen Einheit 11 sind außerdem eine erste Schnittstelle 13 und eine zweite Schnittstelle 14 untergebracht, die mit der lokalen Versorgungsleitung 12 verbunden sind. Die erste Schnittstelle 13 ist hierbei mit dem Bussystem 6 verbunden, um Daten von dem Bussystem 6 zu empfangen und um Daten über das Bussystem 6 auszugeben. Die zweite Schnittstelle 14 ist primär aus Sicherheitsgründen vorhanden, wobei sie mit dem Bussystem 6 und mit der ersten Schnittstelle 13 verbunden ist und die erste Schnittstelle 13 überwacht. Insbesondere kann über die erste Schnittstelle 13 und über die zweite Schnittstelle 14 eine Kommunikation mit der zentralen Steuerung 5 erfolgen.

In diesem Ausführungsbeispiel ist außerdem eine RFID-Schnittstelle 15 vorhanden, die ebenfalls über die Schnittstelle 14 mit dem Bussystem 6 verbunden ist. Die RFID-Schnittstelle 15 ermöglicht im normalen Betrieb einen Zutritt über Benutzerausweise 16, in denen individuelle RFID-Kennzeichen enthalten sind. Durch die Signalmuster der RFID-Kennzeichen der Benutzerausweise 16 kann die Aufzugskabine gerufen werden.

Die Überwachungsanlage 1 weist außerdem eine Abfrageeinrichtung 20 auf. Die Abfrageeinrichtung 20 kann hierbei auch Bestandteil einer Steuereinrichtung 20 sein. Die Abfrageeinrichtung 20 tauscht im vorliegenden Beispiel mit der ersten Schnittstelle 13 Daten aus. Selbstverständlich kann die Abfrageeinrichtung auch mit der zweiten Schnittstelle 14 oder über beide Schnittstellen Daten austauschen. Hierbei kann die Abfrageeinrichtung 20 über die erste Schnittstelle 13 und/oder die zweite Schnittstelle 14 Daten von dem Bussystem 6 erhalten und an das Bussystem 6 ausgeben. Somit kann die Schnittstelle 14 sowohl von der RFID-Schnittstelle 15 als auch von der Abfrageeinrichtung 20 genutzt werden, um über das Bussystem 6 beispielsweise mit der Aufzugssteuerung, insbesondere der zentralen Steuerung 5, zu kommunizieren. Es kann auch nur eine gemeinsame Schnittstelle vorhanden sein, so dass die Abfrageeinrichtung 20 und die RFID-Schnittstelle 15 nur über diese gemeinsame Schnittstelle mit dem Bussystem 6 verbunden sind.

Die Überwachungsanlage 1 weist einen Sicherheitsschalter 21 auf, der über einen elektrischen Sicherheitskreis 22 mit der Abfrageeinrichtung 20 verbunden ist. Der Sicherheitsschalter 21 dient zur Überwachung der Einrichtung 3, die in diesem Ausführungsbeispiel als Türschloss 3 ausgestaltet ist. Hierbei kann der Sicherheitsschalter 21 auch ganz oder teilweise in solch eine Einrichtung 3 integriert sein. Die Abfrageeinrichtung 20 legt eine Prüfspannung an den elektrischen Sicherheitskreis 21 an, um den Schaltzustand des Sicherheitsschalters 21 abzufragen.

In diesem Ausführungsbeispiel ist der Sicherheitsschalter 21 als umschaltbarer Sicherheitsschalter 21 ausgestaltet. In einer ersten Schaltstellung schließt der Sicherheitsschalter 21 den elektrischen Sicherheitskreis 22 über ein erstes Leitungsstück 23, das mit einem ersten Eingangs- und/oder Ausgangsanschluss 24 verbunden ist. Diese erste Schaltstellung des Sicherheitsschalters 21 ist in der Figur 1 dargestellt. In einer zweiten Schaltstellung schließt der Sicherheitsschalter 21 den elektrischen Sicherheitskreis 22 über ein zweites Leitungsstück 25, das mit einem zweiten Eingangs- und/oder Ausgangsanschluss 26 verbunden ist. Neben dem ersten Eingangs- und/oder Ausgangsanschluss 24 und dem zweiten Eingangs- und/oder Ausgangsanschluss 26 weist die Abfrageeinrichtung 20 außerdem einen dritten Eingangs- und/oder Ausgangsanschluss 27 auf, der mit einer Rückleitung 28 verbunden ist. Der Sicherheitsschalter 21 schließt in der ersten Schaltstellung den Sicherheitskreis 22 über das erste Leitungsstück 23 und die Rückleitung 28. Ferner schließt der Sicherheitsschalter 21 in der zweiten Schaltstellung den Sicherheitskreis 22 über das zweite Leitungsstück 25 und die Rückleitung 28. Somit ist eine Antivalenz gegeben, bei der immer ein Leitungsweg geschlossen und der andere offen ist. Somit ist eine sichere Abfrage des Sicherheitsschalters 21 durch die Verwendung des zwangsgeführten Sicherheitsschalters 21 sichergestellt.

Die Überwachungsanlage 1 weist eine unabhängige Energieversorgungseinrichtung 30 auf, die an der Abfrageeinrichtung 20 angeordnet ist. In diesem Ausführungsbeispiel befinden sich die unabhängige Energieversorgungseinrichtung 30 und die Abfrageeinrichtung 20 beide innerhalb der baulichen Einheit 11. Insbesondere können die unabhängige Energieversorgungseinrichtung 30 und die Abfrageeinrichtung 20 innerhalb eines gemeinsamen Gehäuses untergebracht sein. Die unabhängige Energieversorgungseinrichtung 30 weist in diesem Ausführungsbeispiel mehrere Akkumulatorelemente 31 auf. Über die unabhängige Energieversorgungseinrichtung 30 ist die Abfrageeinrichtung 20 mit Energie, insbesondere mit einer geeigneten Versorgungsspannung, versorgbar. Die Versorgungsspannung kann beispielsweise 3 V betragen.

In diesem Ausführungsbeispiel ist außerdem ein Ladegerät 32 vorhanden, das über die lokale Versorgungsleitung 12 gespeist wird. Die Speisung des Ladegeräts 32 ist hierbei von der externen Energieversorgung 7 abhängig. Durch das Ladegerät 32 können die Akkumulatorelemente 31 der unabhängigen Energieversorgungseinrichtung 30 stets in einem zumindest teilweise geladenen Zustand gehalten werden. Ferner ist über das Ladegerät 32 und die unabhängige Energieversorgungseinrichtung 30 auch eine mittelbare Versorgung der Abfrageeinrichtung 20 mit Energie von der externen Energieversorgung 7 möglich, solange die externe Energieversorgung 7 aktiv ist.

Wenn die externe Energieversorgung 7 unterbrochen ist, dann ist auch eine Energieversorgung über die lokale Versorgungsleitung 12 unterbrochen. Allerdings wird die Abfrageeinrichtung 20 dann weiterhin mit Energie versorgt, nämlich von der unabhängigen Energieversorgungseinrichtung 30. Somit ist auch bei einem Stromausfall eine zuverlässige Abfrage des Sicherheitsschalters 21 möglich.

Wenn die Abfrageeinrichtung 20 erkennt, dass der Sicherheitsschalter 21 zeitweise in der zweiten Schaltstellung ist, dann wird beispielsweise ein entsprechendes Kennzeichen gesetzt. Wenn die externe Energieversorgung 7 wieder aktiv ist, dann kann aufgrund des gesetzten Kennzeichens eine entsprechende Meldung über das Bussystem 6 an die zentrale Steuerung 5 erfolgen.

Somit ist die Abfrageeinrichtung 20 von der unabhängigen Energieversorgungseinrichtung 30 versorgbar. Hierbei ist die Abfrageeinrichtung 20 zusätzlich zumindest mittelbar von der externen Energieversorgung 7 versorgbar. Bei einer Unterbrechung der externen Energieversorgung 7 ist die Abfrageeinrichtung 20 dann von der unabhängigen Energieversorgungseinrichtung 30 versorgbar. Zusätzlich dient die externe Energieversorgung 7 auch zum Laden des zumindest einen Akkumulatorelements 31 der unabhängigen Energieversorgungseinrichtung 30.

Eine Unterbrechung des elektrischen Sicherheitskreises 22 ist somit ebenfalls erfassbar.

Denn dann kann weder über den ersten Eingangs- und/oder Ausgangsanschluss 24 noch über den zweiten Eingangs- und/oder Ausgangsanschluss 26 der Abfrageeinheit 20 ein Signal erfasst werden, wenn die Unterbrechung relevant ist. Somit ist auch eine Fehlfunktion erfassbar.

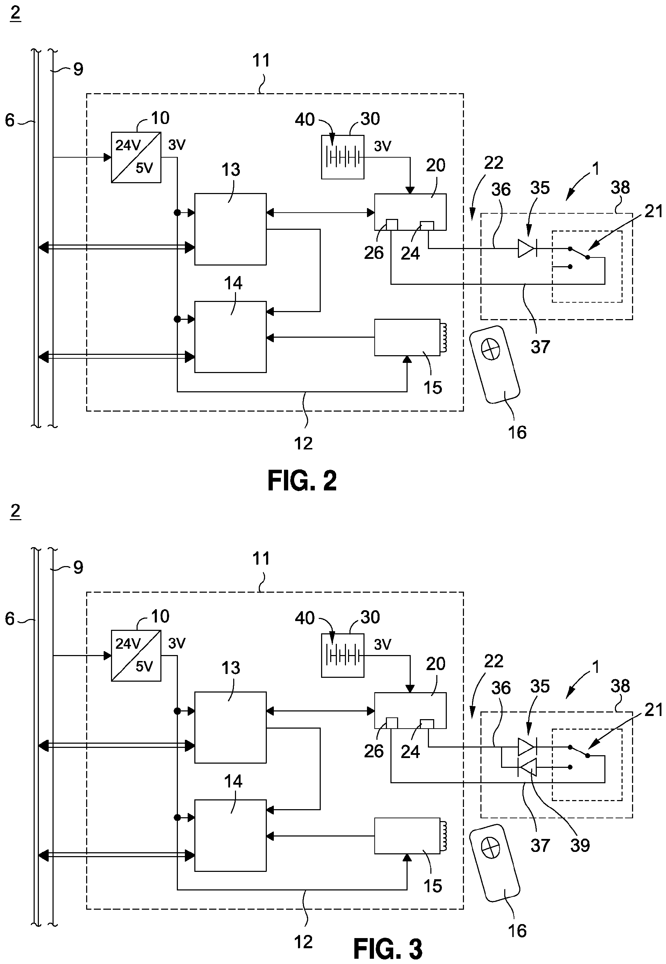

Figur 2 zeigt eine Überwachungsanlage 1 für eine Personentransportanlage 2 in einer auszugsweisen, schematischen Darstellung entsprechend einem zweiten Ausführungsbeispiel. In diesem Ausführungsbeispiel weist die Überwachungseinrichtung 1 den Sicherheitsschalter 21 und eine stromrichtungsabhängige Einheit 35 mit einer stromrichtungsabhängigen Eigenschaft auf. Die stromrichtungsabhängige Einheit 35 ist in diesem Ausführungsbeispiel als Diode ausgestaltet, die in dem Sicherheitskreis 22 angeordnet ist. In diesem Ausführungsbeispiel ist die Diode 35 in einer Leitung 36 angeordnet, die einerseits mit dem ersten Eingangs- und/oder Ausgangsanschluss 24 der Abfrageeinheit 20 und andererseits mit dem Sicherheitsschalter 21 verbunden ist. Ferner ist der Sicherheitsschalter 21 über eine Leitung 37 mit dem zweiten Eingangs- und/oder Ausgangsanschluss 26 verbunden.

Die stromrichtungsabhängige Einheit 35 bildet hierbei mit dem Sicherheitsschalter 21 eine bauliche Einheit 38. Hierbei kann ein PIN der Diode 35 direkt an einem Kontakt beziehungsweise Ausgang des Sicherheitsschalters 21 montiert sein.

Die Abfrageeinrichtung 20 ist in diesem Ausführungsbeispiel so ausgestaltet, dass die Prüfspannung mit einer wechselnden Polarität an den elektrischen Sicherheitskreis 22 angelegt wird. Dadurch kann die durch die stromrichtungsabhängige Einheit 35 vorgegebene stromrichtungsabhängige Eigenschaft des elektrischen Sicherheitskreises 22 abgefragt werden. Falls eine Störung in dem Sicherheitskreis 22 auftritt, die beispielsweise durch einen Kurzschluss entsteht, dann ergibt sich unabhängig von der Polarität der Prüfspannung stets ein Stromfluss. Somit erkennt die Abfrageeinrichtung 20, dass die genannte Störung vorliegt. Ist der Sicherheitsschalter 21 geöffnet, dann ergibt sich unabhängig von der Polarität der Prüfspannung kein Stromfluss. Eine Störung des elektrischen Sicherheitskreises 22, die beispielsweise ein Leitungsbruch ist, kann hierbei entsprechend einem geöffneten Sicherheitsschalter 21 behandelt werden. Nach einer Unterbrechung der Aufzugsanlage untersucht die Serviceperson dann, was die Ursache für die Unterbrechung war. Durch die Diode 36 besteht die stromrichtungsabhängige Eigenschaft darin, dass der Strom entweder gesperrt oder durchgelassen wird. Bei einer abgewandelten Ausgestaltung sind allerdings auch andere stromrichtungsabhängige Eigenschaften erzielbar. Insbesondere können auch in Abhängigkeit von der Stromrichtung unterschiedliche Widerstandswerte abgefragt werden.

Für die Abfrage des elektrischen Sicherheitskreises 22 steht auch in diesem Ausführungsbeispiel die unabhängige Energieversorgungseinrichtung 30 zur Verfügung. In diesem Ausführungsbeispiel weist die unabhängige Energieversorgungseinrichtung 30 mehrere Batterieelemente 40 auf. Die Batterieelemente 40 können hierbei im Rahmen einer vorgegebenen Wartung überprüft und gegebenenfalls ausgetauscht werden. Figur 3 zeigt eine Überwachungsanlage 1 für eine Personentransportanlage 2 in einer auszugsweisen, schematischen Darstellung entsprechend einem dritten Ausführungsbeispiel. In diesem Ausführungsbeispiel schließt der Sicherheitsschalter 21 den Sicherheitskreis 22 in einer ersten Schaltstellung über die Diode 35. Die erste Schaltstellung des Sicherheitsschalters 21 ist in der Figur 3 dargestellt. In einer zweiten Schaltstellung des Sicherheitsschalters 21 ist der elektrische Sicherheitskreis 22 über eine weitere stromrichtungsabhängige Einheit 39 mit einer stromrichtungsabhängigen Eigenschaft geschlossen. Die weitere stromrichtungsabhängige Einheit 39 ist in diesem Ausführungsbeispiel als Diode 39 ausgebildet. Hierbei unterscheiden sich die stromrichtungsabhängigen Eigenschaften der stromrichtungsabhängigen Einheiten 35, 39 voneinander. In diesem Ausführungsbeispiel ist dies dadurch erreicht, dass die Dioden 35, 39 bezüglich einer Stromrichtung vom Anschluss 26 zum Anschluss 24 bei der jeweiligen Schaltstellung des Sicherheitsschalters 21 gewissermaßen antiparallel zueinander geschaltet sind.

Somit ergibt sich in diesem Ausführungsbeispiel in Abhängigkeit von der Polarität der Prüfspannung folgendes Verhalten. In der ersten Schaltstellung des Sicherheitsschalters 21 sperrt die Diode 35 den Stromfluss von dem Anschluss 26 zu dem Anschluss 24, während ein Stromfluss von dem Anschluss 24 zu dem Anschluss 26 durchgelassen wird. Umgekehrt sperrt die Diode 39 in der zweiten Schaltstellung des Sicherheitsschalters 21 den Stromfluss von dem Anschluss 24 zu dem Anschluss 26, während der Stromfluss von dem Anschluss 26 zu dem Anschluss 24 durchgelassen wird. Somit ergibt sich aus der Abfrage des Sicherheitsschalters 21 mit der Prüfspannung von wechselnder Polarität eindeutig, ob sich der Sicherheitsschalter 21 in der ersten Schaltstellung oder in der zweiten Schaltstellung befindet.

Außerdem können auch Störungen in verbesserter Weise erfasst werden. Bei einer Leitungsunterbrechung in der Leitung 36 und/oder in der Leitung 37 kommt es unabhängig von der Polarität der Prüfspannung zu keinem Stromfluss. Somit ist solch eine Störung eindeutig von den beiden möglichen Schaltzuständen des Sicherheitsschalters 21 unterscheidbar. Bei einem Kurzschluss zwischen den Leitungen 36, 37 kommt es unabhängig von der Polarität der Prüfspannung stets zu einem Stromfluss. Somit ist auch solch eine Störung eindeutig von den beiden Schaltstellungen des Sicherheitsschalters 21 unterscheidbar.

Daher können bei dem anhand der Figur 3 beschriebenen Ausführungsbeispiel alle vier Zustände, nämlich die beiden Schaltstellungen des Sicherheitsschalters 21, eine Leitungsunterbrechung und ein Kurzschluss, voneinander unterschieden werden. Dies erleichtert eine Fehlererkennung und Fehlerauswertung.

Für die Abfrage des elektrischen Sicherheitskreises 22 steht auch in diesem Ausführungsbeispiel die unabhängige Energieversorgungseinrichtung 30 zur Verfügung. In diesem Ausführungsbeispiel weist die unabhängige Energieversorgungseinrichtung 30 mehrere Batterieelemente 40 auf. Die Batterieelemente 40 können hierbei im Rahmen einer vorgegebenen Wartung überprüft und gegebenenfalls ausgetauscht werden.

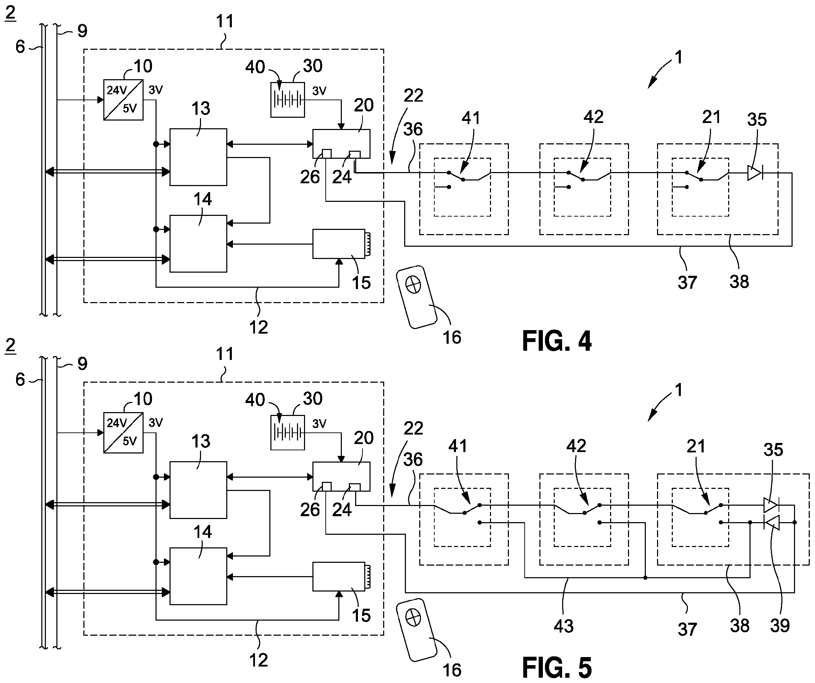

Figur 4 zeigt eine Überwachungsanlage 1 für eine Personentransportanlage 2 in einer auszugsweisen, schematischen Darstellung entsprechend einem vierten Ausführungsbeispiel. In diesem Ausführungsbeispiel sind in dem elektrischen Sicherheitskreis 22 der Sicherheitsschalter 21 und weitere Sicherheitsschalter 41, 42 angeordnet. Die Sicherheitsschalter 21, 41, 42 sind in Serie geschaltet. In einer ersten Kombination von Schaltstellungen der Sicherheitsschalter 35, 41, 42 ist der Sicherheitskreis 22 geschlossen. Diese erste Kombination von Schaltstellungen ist in der Figur 4 dargestellt. In jeder anderen Kombination von Schaltstellungen ist der Sicherheitskreis 22 an zumindest einem der Sicherheitsschalter 21, 41, 42 unterbrochen. Somit ist der elektrische Sicherheitskreis 22 in jeder anderen Kombination von Schaltstellungen unterbrochen.

In der ersten Kombination von Schaltstellungen kann die stromrichtungsabhängige Eigenschaft der Einheit 35, die als Diode 35 ausgebildet ist, abgefragt werden. In der ersten Kombination von Schaltstellungen wird nur bei einer Polarität der Prüfspannung ein Stromfluss erzeugt. Dadurch wird festgestellt, dass der elektrische Sicherheitskreis 22 geschlossen ist. Die Abfrageeinrichtung 20 wird hierbei auch während einer Stromunterbrechung von der unabhängigen Energieversorgungseinrichtung 30 gespeist.

Bei einer Störung, die ein Kurzschluss zwischen den Leitungen 36, 37 ist, wird für beide Polaritäten der Prüfspannung ein Stromfluss erzielt. Somit kann solch eine Störung eindeutig erkannt werden. Bei einer Störung, die eine Unterbrechung auf zumindest einer der Leitungen 36, 37 ist, wird für keine der beiden Polaritäten der Prüfspannung ein Stromfluss erzeugt. Somit kann auch diese Störung erkannt werden.

Die Sicherheitsschalter 41, 42 dienen zum Überwachen weiterer Einrichtungen, die entsprechend der Einrichtung 3 ausgestaltet sein können. Somit kann beispielsweise auf einem Stockwerk eine Überwachung von mehreren Türschlössern 3 erfolgen. Für diese Überwachung sind nur zwei Anschlüsse 24, 26 der Abfrageeinrichtung 20 erforderlich. Dies verringert die Herstellungskosten. Außerdem kann mit zwei Leitungen 36, 37 ein Sicherheitskreis 22 gebildet werden.

Figur 5 zeigt eine Überwachungsanlage 1 für eine Personentransportanlage 2 entsprechend einem fünften Ausführungsbeispiel. In diesem Ausführungsbeispiel weist der Sicherheitskreis 22 im Unterschied zu dem anhand der Figur 4 beschriebenen vierten Ausführungsbeispiel zusätzlich eine Überbrückungsleitung 43 und eine weitere stromrichtungsabhängige Einheit 39 auf.

Hierbei ist der elektrische Sicherheitskreis 22 in der ersten Kombination von Schaltstellungen über die stromrichtungsabhängige Einheit 35 geschlossen. Die erste Kombination von Schaltstellungen ist in der Figur 5 dargestellt. In jeder anderen Kombination von Schaltstellungen ist der elektrische Sicherheitskreis 22 mittels der Überbrückungsleitung 43 über die weitere stromrichtungsabhängige Einheit 39 geschlossen. Somit wird in der ersten Kombination von Schaltstellungen die stromrichtungsabhängige Eigenschaft der Einheit 35 abgefragt, während in jeder anderen Kombination von Schaltstellungen die stromrichtungsabhängige Eigenschaft der weiteren Einheit 39 abgefragt wird. Durch Anlegen der Prüfspannung mit der wechselnden Polarität kann somit eindeutig erkannt werden, ob die erste Kombination von Schaltstellungen vorliegt oder ob eine andere Kombination von Schaltstellungen vorliegt. Dies kann zudem gegenüber Störungen, wie einem Kurzschluss oder einem Leitungsbruch, abgegrenzt werden. Bei einem Kurzschluss zwischen den Leitungen 36, 37 besteht unabhängig von der Polarität der Prüfspannung stets ein Stromfluss. Bei einer Unterbrechung auf zumindest einer der Leitungen 36, 37 ergibt sich unabhängig von der Polarität der Prüfspannung kein Stromfluss. Bei einem Kurzschluss im Bereich der Sicherheitsschalter 21, 41, 42 wird außerdem ein abweichendes Verhalten erfasst, sobald die Schaltstellung relevant wird. Beispielsweise kann durch einen Kurzschluss der Sicherheitsschalter 42 überbrückt sein. Wenn nun der Sicherheitsschalter 42 aus der in der Figur 5 dargestellten Schaltstellung umgeschaltet wird, dann ergibt sich unabhängig von der Polarität der Prüfspannung ein Stromfluss. Denn in der einen Richtung fließt der Strom über den kurzgeschlossenen Sicherheitsschalter 42 und über die Diode 35. In der anderen Richtung fließt der Strom über die Diode 39 und die am Sicherheitsschalter 42 auf die Leitung 36 geschaltete Überbrückungsleitung 43. Dies ist genau das Prüfbild, das einem Kurzschluss entspricht. Somit kann auch ein Kurzschluss auf einem der Sicherheitsschalter 21, 41, 42 erkannt werden, wenn dieser relevant wird.

Je nach Ausgestaltung der Überwachungsanlage 1 können auch mehrere bauliche Einheiten 11 vorhanden sein, die auf unterschiedlichen Stockwerken angeordnet sind. Hierbei kann eine gemeinsame Kommunikation über genau ein Bussystem 6 erfolgen. Bei einer abgewandelten Ausgestaltung können allerdings auch mehrere Sicherheitsschalter 21, 41, 42 über mehrere Stockwerke verteilt sein, die über eine Abfrageeinrichtung 20 abgefragt werden. Außerdem können unterschiedliche Ausgestaltungen hinsichtlich der Fehlermeldung oder Fehlerabfrage realisiert werden. Insbesondere kann die zentrale Steuerung 5 die Schalterüberwachung abfragen. Zusätzlich oder alternativ kann auch eine selbständige Meldung an die zentrale Steuerung 5 erfolgen.

Somit ergibt sich auch der Vorteil, dass bei selten betätigten Sicherheitsschaltern 21, 41, 42 ein Unterbruch der im Schließerpfad liegenden Leitung erkannt werden kann, so dass auch ein gegebenenfalls später erfolgender Zweitfehler, beispielsweise ein Kurzschluss im Öffnerpfad, nicht zu einem sicherheitsrelevanten Fehler führen kann.

Eine sichere Abfrage einer Einrichtung 3 kann hierbei über eine einfache Zweidrahtleitung oder aber auch über eine Dreidrahtleitung erzielt werden. Die Abfrage des Schaltzustandes wird über die Prüfspannung mit der wechselnden Polarität ermöglicht, was sporadisch oder mit schnell wechselnder Frequenz erfolgen kann.

Die Eingangs- und/oder Ausgangsanschlüsse 24, 26, 27 können in abwechselnder Weise als Eingangsanschluss 24, 26, 27 und Ausgangsanschluss 24, 26, 27 dienen. Insbesondere kann hierbei abwechslungsweise eine vorgegebene Spannung an den jeweiligen Eingangs- und/oder Ausgangsanschluss 24, 26, 27 gegeben werden und gegen einen anderen Eingangs- und/oder Ausgangsanschluss 24, 26, 27 gemessen werden. Dadurch liegt die Spannung einmal positiv und einmal negativ an dem Sicherheitskreis 22 an, wenn eine bestimmte Durchlaufrichtung definiert wird.

Die stromrichtungsabhängige Einheit 35 und gegebenenfalls die weitere stromrichtungsabhängige Einheit 39 sind vorzugsweise am letzten Sicherheitsschalter 21 angebracht. Somit kann die Anzahl der für jeden Strompfad erforderlichen Dioden 35, 39 reduziert werden.

Obwohl die Erfindung durch die Darstellung spezifischer Ausführungsbeispiele beschrieben worden ist, ist es offensichtlich, dass zahlreiche weitere Ausführungsvarianten in Kenntnis der vorliegenden Erfindung geschaffen werden können. Beispielsweise können verschiedenste sicherheitsrelevante Schalter der Personentransportanlage, beispielsweise auch Kabinentüren, Zugangstüren von Maschinenräumen und dergleichen mehr, durch die erfindungsgemäße Überwachungseinrichtung ergänzt beziehungsweise überwacht werden.

## Patentansprüche

1. Überwachungsanlage (1) für Personentransportanlagen (2), die als Aufzug, Rolltreppe oder Fahrsteig ausgestaltet sind, mit zumindest einer Abfrageeinrichtung (20) und zumindest einem über einen elektrischen Sicherheitskreis (22) mit der Abfrageeinrichtung (20) verbundenen Sicherheitsschalter (21), der zur Überwachung einer Einrichtung (3) der Personentransportanlage (2) dient, wobei der Sicherheitsschalter (21) mindestens zwei Schaltstellungen aufweist, **dadurch gekennzeichnet,**
• **dass** eine unabhängige Energieversorgungseinrichtung (30) vorhanden ist, welche die Abfrageeinrichtung (20) mit elektrischer Energie versorgt,
• **dass** unabhängig vom Vorhandensein einer externen Energieversorgung (7) der Personentransportanlage (2) mittels der Abfrageeinrichtung (20) eine Änderung der Schaltstellung des Sicherheitsschalters (21) erfassbar ist und
• **dass** aus der Änderung der Schaltstellung mindestens ein Zustandssignal generierbar ist.

2. Überwachungsanlage nach Anspruch 1, wobei die unabhängige Energieversorgungseinrichtung (30) an der Abfrageeinrichtung (20) angeordnet ist und/oder die Abfrageeinrichtung (20) ausgestaltet ist, eine Prüfspannung an den elektrischen Sicherheitskreis (22) anzulegen.

3. Überwachungsanlage nach Anspruch 1 oder 2, wobei die unabhängige Energieversorgungseinrichtung (30) zumindest ein Batterieelement (40) und/oder zumindest ein Akkumulatorelement (31) aufweist.

4. Überwachungsanlage nach Anspruch 3, wobei solange eine externe Energieversorgung (7) vorhanden ist, die Abfrageeinrichtung (20) durch diese externe Energieversorgung (7) versorgbar ist und die Abfrageeinrichtung (20) bei einer Unterbrechung der externen Energieversorgung (7) von der unabhängigen Energieversorgungseinrichtung (30) versorgt ist und/oder die externe Energieversorgung (7) zum Laden des zumindest einen Akkumulatorelements (31) dient.

5. Überwachungsanlage nach einem der Ansprüche 1 bis 4, wobei
• der Sicherheitsschalter (21) als umschaltbarer Sicherheitsschalter (21) ausgestaltet ist,
• der Sicherheitsschalter (21) in einer ersten Schaltstellung den elektrischen Sicherheitskreis (22) über ein erstes Leitungsstück (23), das zumindest mittelbar mit der Abfrageeinrichtung (20) verbunden ist, schließt, und
• der Sicherheitsschalter (21) in einer zweiten Schaltstellung den elektrischen Sicherheitskreis (22) über ein zweites Leitungsstück (25), das zumindest mittelbar mit der Abfrageeinheit (20) verbunden ist, schließt.

6. Überwachungsanlage nach Anspruch 5, wobei
• das erste Leitungsstück (23) mit einem ersten Eingangs- und/oder Ausgangsanschluss (24) der Abfrageeinrichtung (20) verbunden ist,
• das zweite Leitungsstück (25) mit einem zweiten Eingangs- und/oder Ausgangsanschluss (26) der Abfrageeinrichtung (20) verbunden ist,
• eine Rückleitung (28) vorhanden ist, die mit einem dritten Eingangs- und/oder Ausgangsanschluss (27) der Abfrageeinrichtung (20) verbunden ist,
• der Sicherheitsschalter (21) in der ersten Schaltstellung den elektrischen Sicherheitskreis (22) über das erste Leitungsstück (23) und die Rückleitung (28) schließt und
• der Sicherheitsschalter (21) in der zweiten Schaltstellung den elektrischen Sicherheitskreis (22) über das zweite Leitungsstück (25) und die Rückleitung (28) schließt.

7. Überwachungsanlage nach einem der Ansprüche 1 bis 4, wobei in dem elektrischen Sicherheitskreis (22) zumindest eine stromrichtungsabhängige Einheit (35) vorhanden ist, und ferner die Abfrageeinrichtung (20) ausgestaltet ist, eine Prüfspannung mit einer wechselnden Polarität an den elektrischen Sicherheitskreis (22) anzulegen.

8. Überwachungsanlage nach Anspruch 7, wobei der zumindest eine Sicherheitsschalter (21, 41, 42) in einer ersten Schaltstellung beziehungsweise in einer ersten Kombination von Schaltstellungen den elektrischen Sicherheitskreis (22) über die stromrichtungsabhängige Einheit (35) schließt.

9. Überwachungsanlage nach Anspruch 8, wobei der zumindest eine Sicherheitsschalter (21, 41, 42) in einer zweiten Schaltstellung beziehungsweise in einer anderen Kombination von Schaltstellungen, die sich von der ersten Kombination von Schaltstellungen unterscheidet, den elektrischen Sicherheitskreis (22) öffnet.

10. Überwachungsanlage nach Anspruch 8, wobei der zumindest eine Sicherheitsschalter (21, 41, 42) in einer zweiten Schaltstellung beziehungsweise in einer anderen Kombination von Schaltstellungen, die sich von der ersten Kombination von Schaltstellungen unterscheidet, den elektrischen Sicherheitskreis (22) nicht über die stromrichtungsabhängige Einheit (35), sondern über eine weitere Einheit stromrichtungsabhängige (39) schließt.

11. Überwachungsanlage nach einem der Ansprüche 7 bis 10, wobei die Abfrageeinrichtung (20) ausgestaltet ist, die Prüfspannung stets zwischen einem ersten Anschluss (24) und einem zweiten Anschluss (26) an den elektrischen Sicherheitskreis (22) anzulegen.

12. Überwachungsanlage nach einem der Ansprüche 1 bis 11, wobei eine Steuereinrichtung (20) vorhanden ist, die die Abfrageeinrichtung (20) umfasst, und dass die Steuereinrichtung (20) bei einer Betätigung der Einrichtung (3), die von dem Sicherheitsschalter (21) überwacht ist, über eine Schnittstelle (13, 14) und ein Bussystem (6) die Betätigung an eine zentrale Steuerung (5) meldet.

13. Überwachungsanlage nach Anspruch 12, wobei eine RFID-Schnittstelle (15) vorhanden ist und dass die RFID-Schnittstelle (15) über die Schnittstelle (13, 14) mit dem Bussystem (6) verbunden ist.

14. Personentransportanlage (2), die als Aufzug, Rolltreppe oder Fahrsteig ausgestaltet ist, mit einer Überwachungsanlage (1) nach einem der Ansprüche 1 bis 13 und zumindest einer zu überwachenden Einrichtung (3), der ein Sicherheitsschalter (21) der Überwachungsanlage (1) zugeordnet ist.

15. Verfahren zur Überwachung einer Personentransportanlage (2), die als Aufzug, Rolltreppe oder Fahrsteig ausgestaltet ist, wobei durch einen elektrischen Sicherheitskreis (22) mit zumindest einem Sicherheitsschalter (21) zumindest eine Einrichtung (3) der Personentransportanlage (2) überwacht wird, **dadurch gekennzeichnet, dass** eine unabhängige Energieversorgungseinrichtung (30) vorhanden ist, welche eine Abfrageeinrichtung (20) mit elektrischer Energie versorgt und die Überwachung des elektrischen Sicherheitskreises (22) zumindest zeitweise mittels der Abfrageeinrichtung (20) durch das Aufbringen einer Prüfspannung erfolgt, so dass unabhängig vom Vorhandensein einer externen Energieversorgung (7) der Personentransportanlage (2) mittels der Abfrageeinrichtung (20) eine Änderung der Schaltstellung des Sicherheitsschalters (21) erfasst werden kann und aus der Änderung der Schaltstellung mindestens ein Zustandssignal generiert werden kann.

## Claims

1. Monitoring system (1) for transport installations (2) for persons, which installations are arranged as elevator, escalator or moving walkway, comprising at least one interrogation device (20) and at least one safety switch (21), which is connected with the interrogation device (20) by way of an electrical safety circuit (22) and which serves for monitoring an item of equipment (3) of the transport installation (2) for persons, wherein the safety switch (21) has at least two switch settings, **characterised in that**
- an independent energy supply device (30) which supplies the interrogation unit (20) with electrical energy is present,
- independently of the presence of an external energy supply means (7) of the transport installation (2) for persons a change in the switch setting of the safety switch (21) is detectable by means of the interrogation device (20) and
- at least one status signal can be generated from the change in the switch setting.

2. Monitoring system according to claim 1, wherein the independent energy supply device (30) is arranged at the interrogation device (20) and/or the interrogation device (20) is arranged to apply a test voltage to the electrical safety circuit (22).

3. Monitoring system according to claim 1 or 2, wherein the independent energy supply device (30) comprises at least one battery element (40) and/or at least one accumulator element (31).

4. Monitoring system according to claim 3, wherein as long as an external energy supply means (7) is present the interrogation device (20) can be supplied by this external energy supply means (7) and the interrogation device (20) in the case of interruption of the external energy supply means (7) is supplied with power from the independent energy supply device (30) and/or the external energy supply means (7) serves for charging the at least one accumulator element (31).

5. Monitoring system according to any one of claims 1 to 4, wherein
- the safety switch (21) is constructed as a safety switch (21) which can be switched over,
- the safety switch (21) in a first switch setting closes the electrical safety circuit (22) by way of a first line section (23), which is connected at least indirectly with the interrogation device (20), and
- the safety switch (21) in a second switch setting closes the electrical safety circuit (22) by way of a second line section (25), which is connected at least indirectly with the interrogation device (20).

6. Monitoring system according to claim 5, wherein
- the first line section (23) is connected with a first input terminal and/or output terminal (24) of the interrogation device (20),
- the second line section (25) is connected with a second input terminal and/or output terminal (26) of the interrogation device (20),
- a return line (28), which is connected with a third input terminal and/or output terminal (27) of the interrogation device (20), is present,
- the safety switch (21) in the first switch setting closes the electrical safety circuit (22) by way of the first line section (23) and the return line (28) and
- the safety switch (21) in the second switch setting closes the electrical safety circuit (22) by way of the second line section (25) and the return line (28).

7. Monitoring system according to any one of claims 1 to 4, wherein at least one unit (35) with dependency on current direction is present in the electrical safety circuit (22) and in addition the interrogation device (20) is arranged to apply a test voltage with a changing polarity to the electrical safety circuit (22).

8. Monitoring system according to claim 7, wherein the at least one safety switch (21, 41, 42) in a first switch setting or in a first combination of switch settings closes the electrical safety circuit (22) by way of the unit (35) with dependency on current direction.

9. Monitoring system according to claim 8, wherein the at least one safety switch (21, 41, 42) in a second switch setting or in another combination of switch settings differing from the first combination of switch settings opens the electrical safety circuit (22).

10. Monitoring system according to claim 8, wherein the at least one safety switch (21, 41, 42) in a second switch setting or in another combination of switch settings differing from the first combination of switch settings closes the electrical safety circuit (22) not by way of the unit (35) with dependency on current direction, but by way a further unit (39) with dependency on current direction.

11. Monitoring system according to any one of claims 7 to 10, wherein the interrogation device (20) is arranged to apply the test voltage to the electrical safety circuit (22) always between a first terminal (24) and a second terminal (26).

12. Monitoring system according to any one of claims 1 to 11, wherein a control device (20) comprising the interrogation device (20) is present and the control device (20) in the case of actuation of the item of equipment (3) monitored by the safety switch (21) reports the actuation to a central control (5) by way of an interface (13, 14) and a bus system (6).

13. Monitoring system according to claim 12, wherein an RFID interface (15) is present and the RFID interface (15) is connected with the bus system (6) by way of the interface (13, 14).

14. Transport installation (2) for persons, which is arranged as a elevator, an escalator or a moving walkway, comprising a monitoring system (1) according to any one of claims 1 to 13 and at least one item of equipment (3), which is to be monitored and with which a safety switch (21) of the monitoring system (1) is associated.

15. Method of monitoring a transport installation (2) for persons, which is arranged as elevator, escalator or moving walkway, wherein at least one item of equipment (3) of the transport installation (2) for persons is monitored by an electrical safety circuit (22) comprising at least one safety switch (21), **characterised in that** an independent energy supply device (30) supplying the interrogation device (20) with electrical energy is present and monitoring of the electrical safety circuit (22) is carried out at least at times by means of the interrogation device (20) by application of a test voltage so that independently of the presence of an external energy supply means (7) of the transport installation (2) for persons a change in the switch setting of the safety switch (21) can be detected by means of the interrogation device (20) and at least one status signal can be generated from the change in the switch setting.

## Revendications

1. Installation de surveillance (1) pour des installations de transport de personnes (2) qui sont conçues comme un ascenseur, un escalier roulant ou un trottoir roulant, avec au moins un dispositif d'interrogation (20) et au moins un commutateur de sécurité (21) qui est relié au dispositif d'interrogation (20) par l'intermédiaire d'un circuit de sécurité électrique (22) et qui sert à surveiller un dispositif (3) de l'installation de transport de personnes (2), le commutateur de sécurité (21) présentant au moins deux positions de commutation, **caractérisé**
• **en ce qu'**il est prévu un dispositif d'alimentation en énergie indépendant (30) qui alimente le dispositif d'interrogation (20) en énergie électrique,
• **en ce qu'**indépendamment de la présence d'une alimentation en énergie externe (7) de l'installation de transport de personnes (2), une modification de la position de commutation du commutateur de sécurité (21) peut être détectée à l'aide du dispositif d'interrogation (20), et
• **en ce qu'**au moins un signal d'état peut être généré à partir de la modification de la position de commutation.

2. Installation de surveillance selon la revendication 1, dans laquelle le dispositif d'alimentation en énergie indépendant (30) est disposé sur le dispositif d'interrogation (20), et/ou le dispositif d'interrogation (20) est conçu pour appliquer une tension de contrôle au circuit de sécurité électrique (22).

3. Installation de surveillance selon la revendication 1 ou 2, dans laquelle le dispositif d'alimentation en énergie indépendant (30) comporte au moins un élément de batterie (40) et/ou au moins un élément d'accumulateur (31).

4. Installation de surveillance selon la revendication 3, dans laquelle tant qu'une alimentation en énergie externe (7) est prévue, le dispositif d'interrogation (20) peut être alimenté par cette alimentation en énergie externe (7), et le dispositif d'interrogation (20), en cas d'interruption de cette alimentation en énergie externe (7), est alimenté par le dispositif d'alimentation en énergie indépendant (30), et/ou ladite alimentation en énergie externe (7) sert à charger le ou les éléments d'accumulateur (31).

5. Installation de surveillance selon l'une des revendications 1 à 4, dans laquelle
• le commutateur de sécurité (21) est conçu comme un commutateur de sécurité commutable (21),
• le commutateur de sécurité (21), dans une première position de commutation, ferme le circuit de sécurité (22) par l'intermédiaire d'un premier tronçon de ligne (23) qui est relié au moins indirectement au dispositif d'interrogation (20), et
• le commutateur de sécurité (21), dans une deuxième position de commutation, ferme le circuit de sécurité (22) par l'intermédiaire d'un deuxième tronçon de ligne (25) qui est relié au moins indirectement au dispositif d'interrogation (20).

6. Installation de surveillance selon la revendication 5, dans laquelle
• le premier tronçon de ligne (23) est relié à un premier raccordement d'entrée et/ou de sortie (24) du dispositif d'interrogation (20),
• le deuxième tronçon de ligne (25) est relié à un deuxième raccordement d'entrée et/ou de sortie (26) du dispositif d'interrogation (20),
• il est prévu une ligne de retour (28) qui est reliée à un troisième raccordement d'entrée et/ou de sortie (27) du dispositif d'interrogation (20),
• le commutateur de sécurité (21), dans la première position de commutation, ferme le circuit de sécurité électrique (22) par l'intermédiaire du premier tronçon de ligne (23) et de la ligne de retour (28), et
• le commutateur de sécurité (21), dans la deuxième position de commutation, ferme le circuit de sécurité électrique (22) par l'intermédiaire du deuxième tronçon de ligne (25) et de la ligne de retour (28).

7. Installation de surveillance selon l'une des revendications 1 à 4, dans laquelle il est prévu dans le circuit de sécurité électrique (22) au moins une unité (35) dépendante du sens du courant, et le dispositif d'interrogation (20) est par ailleurs conçu pour appliquer une tension de contrôle avec une polarité alternée au circuit de sécurité électrique (22).

8. Installation de surveillance selon la revendication 7, dans laquelle le ou les commutateurs de sécurité (21, 41, 42), dans une première position de commutation ou dans une première combinaison de positions de commutation, ferment le circuit de sécurité électrique (22) par l'intermédiaire de l'unité (35) dépendante du sens du courant (35).

9. Installation de surveillance selon la revendication 8, dans laquelle le ou les commutateurs de sécurité (21, 41, 42), dans une deuxième position de commutation ou dans une autre combinaison de positions de commutation différente de la première combinaison de positions de commutation, ouvrent le circuit de sécurité électrique (22).

10. Installation de surveillance selon la revendication 8, dans laquelle le ou les commutateurs de sécurité (21, 41, 42), dans une deuxième position de commutation ou dans une autre combinaison de positions de commutation différente de la première combinaison de positions de commutation, ferment le circuit de sécurité électrique (22) non pas par l'intermédiaire de l'unité (35) dépendante du sens du courant, mais par l'intermédiaire d'une autre unité (39) dépendante du sens du courant.

11. Installation de surveillance selon l'une des revendications 7 à 10, dans laquelle le dispositif d'interrogation (20) est conçu pour toujours appliquer la tension de contrôle au circuit de sécurité électrique (22) entre un premier raccordement (24) et un deuxième raccordement (26).

12. Installation de surveillance selon l'une des revendications 1 à 11, dans laquelle il est prévu un dispositif de commande (20) qui comprend le dispositif d'interrogation (20), et le dispositif de commande (20), lors d'un actionnement du dispositif (3) qui est surveillé par le commutateur de sécurité (21), signale l'actionnement à une commande centrale (5) par l'intermédiaire d'une interface (13, 14) et d'un système de bus (6).

13. Installation de surveillance selon la revendication 12, dans laquelle il est prévu une interface RFID (15), et l'interface RFID (15) est reliée au système de bus (6) par l'intermédiaire de l'interface (13, 14).

14. Installation de transport de personnes (2) qui est conçue comme un ascenseur, un escalier roulant ou un trottoir roulant, avec une installation de surveillance (1) selon l'une des revendications 1 à 13 et au moins un dispositif à surveiller (3) auquel est associé un commutateur de sécurité (21) de l'installation de surveillance (1).

15. Procédé pour surveiller une installation de transport de personnes (2) qui est conçue comme un ascenseur, un escalier roulant ou un trottoir roulant, au moins un dispositif (3) de l'installation de transport de personnes (2) étant surveillée par un circuit de sécurité électrique (22) avec au moins un commutateur de sécurité (1), **caractérisé en ce qu'**il est prévu un dispositif d'alimentation en énergie indépendant (30) qui alimente un dispositif d'interrogation (20) en énergie électrique, et la surveillance du circuit de sécurité électrique (22) se fait au moins temporairement à l'aide du dispositif d'interrogation (20) grâce à l'application d'une tension de contrôle, de sorte qu'indépendamment de la présence d'une alimentation en énergie externe (7) de l'installation de transport de personnes (2), une modification de la position de commutation du commutateur de sécurité (21) peut être détectée à l'aide du dispositif d'interrogation (20) et qu'au moins un signal d'état peut être généré à partir de la modification de la position de commutation.
